# EUROPÄISCHE PATENTSCHRIFT

(11) **EP 1 166 610 B1**
(45) Veröffentlichungstag und Bekanntmachung des Hinweises auf die Patenterteilung: **20.11.2002**
(21) Anmeldenummer: 00936687.3
(22) Anmeldetag: 01.04.2000
(51) Int. Cl.: H05K 9/00

(54) **FEDERELEMENT**
SPRING ELEMENT
ELEMENT ELASTIQUE

(30) Priorität: 08.04.1999 DE 29906262 U
(43) Veröffentlichungstag der Anmeldung: 02.01.2002
(73) Patentinhaber: Hermann Stahl GmbH, 71723 Grossbottwar (DE)
(72) Erfinder: STAHL, Hermann, D-71711 Steinheim-Kleinbottwar (DE)
(74) Vertreter: Wasmuth, Rolf, Dipl.-Ing.
(86) Internationale Anmeldenummer: EP0002941
(87) Internationale Veröffentlichungsnummer: WO00060915

(56) Entgegenhaltungen:
- EP-A- 0 425 184
- DE-C- 19 507 846

## Beschreibung

Die Erfindung betrifft ein federndes Kontaktelement zur Anordnung zwischen elektrisch leitenden Gehäuseteilen, insbesondere zwischen einem Einschubgehäuse und einem Einbauschacht, nach dem Oberbegriff des Anspruchs 1.

Elektronische Geräte wie Meßeinschübe oder Computereinheiten, aber auch Geräte der Unterhaltungselektronik wie zum Beispiel ein Autoradio, sind gegen elektromagnetische Störstrahlung ausreichend abzuschirmen. Die Abschirmung wird regelmäßig durch Erdung eines elektrisch leitenden Gehäuses erreicht, wobei ein auswechselbares Einschubgehäuse über Federkontakte mit der Erdung des Einbauschachtes verbunden wird. Dabei müssen die Kontaktfedern auch bei wiederholtem Ein- und Ausbau des Einschubgehäuses eine sichere Kontaktierung gewährleisten.

Ein gattungsgemäßes Kontaktelement ist aus der
DE 195 07 846 C1 bekannt. Ein aus einem formbaren Blech bestehendes Gehäuseteil des Einschubgehäuses oder des Einbauschachtes weist eine einteilig aus einem Schlitz des Bleches ausgeformte Blechlasche auf, welche zur Bildung des federnden Kontaktelementes durch Kaltverformung gegenüber der Dicke des Bleches reduziert ist. Dabei ist die Kontaktfeder über ihre Länge gewellt ausgeführt, wobei sich eine einzelne Welle bogenförmig aus der Ebene des Bleches erhebt. Da das Kontakteiement mit seinem Fußabschnitt an der Schmalseite des Schlitzes festgelegt ist und durch die wellenartige Formgebung eine Längenverkürzung gegeben ist, taucht das Kontaktelement bei starker Beanspruchung in den Schlitz ein, wobei eine elastische Verformung auftreten kann, welche die sichere Kontaktierung stört. Daher wird auch vorgeschlagen, die Kontaktfeder in ihrem freien Ende an der Schmalseite des Schlitzes zu stützen; dies beeinträchtigt aber die Formgebung, da nur eine geringe Längenverkürzung durch die Formgebung zugelassen werden kann.

Der Erfindung liegt die Aufgabe zugrunde, ein federndes Kontaktelement der gattungsgemäßen Art derart auszugestalten, daß es bei freier Wahl der Formgebung eine hohe Federsteifigkeit aufweist.

Die Aufgabe wird erfindungsgemäß nach den kennzeichnenden Merkmalen des Anspruchs 1 gelöst.

Die dem Stützbereich des Kontaktelementes zugeordnete Stützfläche des Bleches erstreckt sich quer zur Laschenlängsachse vom Schlitzlängsrand aus, wodurch eine Abstützung des Kontaktelementes an einem konstruktiv wählbaren Punkt des Schlitzlängsrandes erzielt ist. Somit ist über die gesamte Länge des Schlitzes unabhängig von der durch die Formgebung bedingten Verkürzung des Kontaktelementes eine sichere Abstützung wählbar, welche eine verwindungsfreie Aufnahme von Kräften durch das Kontaktelement gewährleistet. Vorteilhaft liegen sich Stützflächen des Bleches an den Schlitzlängsrändern mit Abstand gegenüber, wodurch links und rechts der Laschenlängsachse am Rand des Schlitzes eine Abstützung vorgesehen ist; eine Verwindung des aus der Blechlasche gebildeten Kontaktelementes um die Laschenlängsachse ist so sicher verhindert.

Vorteilhaft ist der Stützbereich am freien Ende der Blechlasche ausgebildet, so daß deren gesamte Länge zur Federeigenschaft des Kontaktelementes beitragen kann.

Zweckmäßig kann die größte Breite des Stützbereiches vor der Kaltverformung geringfügig größer als der Abstand der Stützflächen sein, was zum Beispiel dadurch erreicht werden kann. daß das freie Ende mit größerer Breite ausgeführt ist als die übrige Blechlasche. Bevorzugt erhält der Stützbereich durch die Kaltverformung die notwendige Breite, um sich an beiden quer zur Schlitzlängsachse mit Abstand etwa gegenüberliegenden Stützflächen am Blech anzulegen.

Wird das freie Ende der Blechlasche in Draufsicht bei der Kaltverformung tellerartig verformt, ist es zweckmäßig, das tellerförmige Ende etwa über einen quer zur Schlitzlängsachse liegenden Durchmesser abzubiegen, wodurch das tellerförmige Ende steifer wird und somit ohne Verformung hohe Stützkräfte auf die Stützflächen abtragen kann.

Weitere Merkmale der Erfindung ergeben sich aus den weiteren Ansprüchen, der Beschreibung und der Zeichnung, in der nachfolgend im einzelnen beschriebene Ausführungsbeispiele der Erfindung dargestellt sind. Es zeigen:
- Fig. 1A: eine Draufsicht auf ein Blech mit einer ausgestanzten Blechlasche in einem Schlitz,
- Fig. 1B: eine Draufsicht auf ein Blech mit einer ausgestanzten, geradlinigen Blechlasche in einem Schlitz,
- Fig. 2: eine Draufsicht auf ein Blech nach Fig. 1 nach der Kaltverformung und Formgebung der Blechlasche,
- Fig. 3: einen Schnitt längs der Linie III-III in Fig. 2.

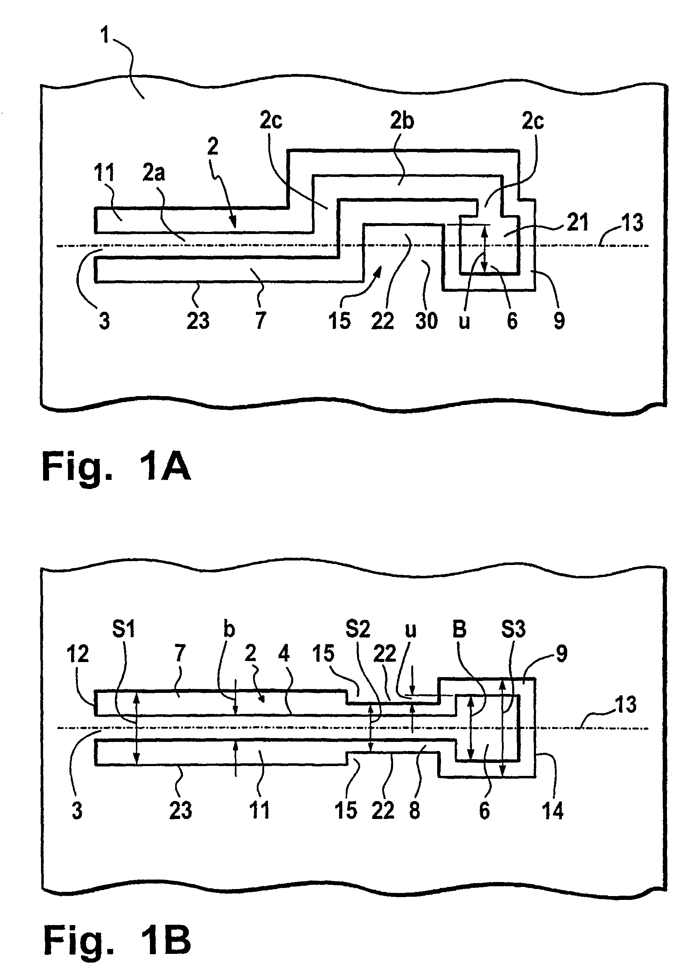

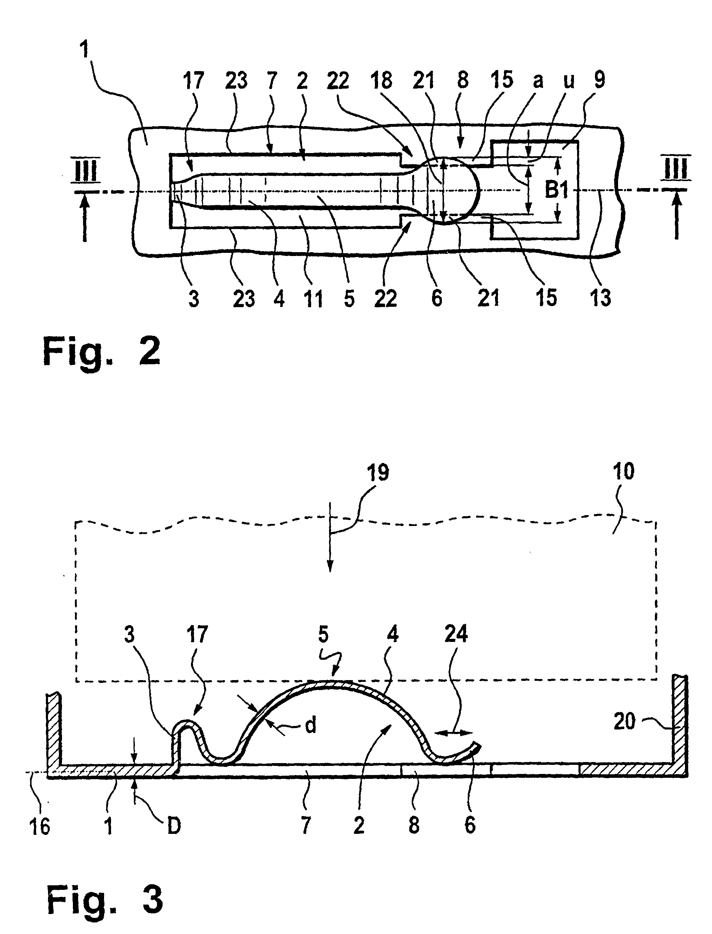

Zur Bildung eines federnden Kontaktelementes, wie es in Seitenansicht in Fig. 3 dargestellt ist, ist in einem Blech 1 eines der Gehäuseteile 10, 20 ein Längsschlitz 11 vorgesehen, in dem eine Blechlasche 2 mit allseitigem Abstand liegt. Im Ausführungsbeispiel nach Fig. 1 schließt die Blechlasche 2 mit einem Fußabschnitt 3 an eine Schmalseite 12 des Längsschlitzes 11 an und erstreckt sich vorzugsweise symmetrisch zur Laschenlängsachse 13 bis zur anderen Schmalseite 14. Im Ausführungsbeispiel ist die mit der Breite b ausgeführte Blechlasche 2 an ihrem freien Ende 6 mit der Breite B ausgeführt. Die Breite B ist größer als die Breite b, wobei das freie Ende 6 bevorzugt etwa die doppelte Breite b der Blechlasche 2 aufweist.

Der Schlitz 11 ist im Bereich des freien Endes 6 mit einem Endabschnitt 9 ausgeführt, dessen quer zur Laschenlängsachse 13 gemessene Breite S3 größer ist als die Breite S1 des Schlitzabschnittes 7, in dem die Blechlasche 2 liegt. Zwischen dem Endabschnitt 9 und dem Schlitzabschnitt 7 ist ein verengter Abschnitt 8 ausgeführt, der durch in den Schlitz 11 einragende Randabschnitte 15 gebildet ist. Die quer zur Schlitzlängsachse 13 gemessene Breite S2 des Abschnittes 8 ist kleiner als die Breite S1 des Schlitzabschnittes 7; die Breite B des freien Endes 6 der Blechlasche 2 ist bevorzugt zumindest geringfügig größer als die Breite S2 des engeren Schlitzabschnittes 8. Im Ausführungsbeispiel nach Fig. 1 ist eine überdeckung u gegeben.

Wie Fig. 2 zeigt, wird die Blechlasche 2 bis auf den Fußbereich 3 durch Kaltverformung gegenüber der Dicke D des Bleches 1 auf die Dicke d der Blechlasche 2 reduziert (Fig. 3). Vorteilhaft kann gleichzeitig eine Formgebung der Blechlasche zu dem federnden Kontaktelement erfolgen, wie es in den Fig. 2 und 3 dargestellt ist. Dabei wird der Fußabschnitt 3 etwa rechtwinklig aus der Blechebene 16 ausgebogen und sein an die Blechlasche 2 anschließender Abschnitt 17 verformt, insbesondere S-förmig gewellt ausgebildet. An den Abschnitt 17 schließt die etwa teilkreisförmig aus der Ebene 16 des Bleches vorstehende Blechlasche 2 an, deren freies Ende 6 vorteilhaft tellerförmig verformt ist. Zur Versteifung des in Draufsicht tellerartig verformten freien Endes 6 ist dieses über einen quer zur Laschenlängsachse 13 liegenden Durchmesser 18 abgebogen.

Im gezeigten Ausführungsbeispiel ist das Blech 1 am Gehäuseteil 20 ausgebildet, welches einen Einbauschacht darstellt; das in Fig. 3 strichliert dargestellte Gehäuseteil 10 bildet das Einschubgehäuse, welches über die als federndes Kontaktelement ausgebildete Blechlasche 2 mit dem geerdeten Einbauschacht elektrisch leitend verbunden wird. Dabei liegt die Kontaktfläche 5 des Kontaktelementes zwischen dem Fußabschnitt 2 und dem tellerartig verformten freien Ende 6 etwa im höchsten Punkt des bogenförmigen Laschenabschnittes 4.

Wird das Einschubgehäuse 10 in Pfeilrichtung 19 in das Einschubgehäuse 20 eingeschoben, federt der bogenförmige Laschenabschnitt um den Fußabschnitt 3, wobei das einen Stützbereich 21 bildende tellerartige Ende 6 auf Stützflächen 22 des Bleches 1 zur Anlage kommt. Im gezeigten Ausführungsbeispiel nach Fig. 1B sind die Stützflächen 22 jeweils am Längsrand 23 des Schlitzes 11 ausgebildet, wobei die Stützflächen 22 durch die quer zur Laschenlängsachse 13 in den Schlitz 11 einragenden Randabschnitte 15 gebildet sind. Durch die sich etwa quer zur Laschenlängsachse 13 mit Abstand a gegenüberliegenden Stützflächen 22 wird das federnde Kontaktelement im entsprechenden Stützbereich 21 des freien Endes 6 beidseitig der Laschenlängsachse 13 abgestützt/ so daß ein Verwinden der Lasche 2 um die Laschenlängsachse 13 ausgeschlossen werden kann. In Pfeilrichtung 19 auf dem bogenförmigen Laschenabschnitt einwirkende Kräfte werden so einerseits durch den S-förmigen Abschnitt 17 im Fußbereich 3 federnd abgefangen und über den Stützbereich 21 am freien Ende 6 auf die Stützflächen 22 des Bleches 1 abgetragen. Das erfindungsgemäß gestaltete federnde Kontaktelement hat eine hohe Federsteifigkeit und gewährleistet auch bei wechselnden Beanspruchungen durch häufigen Ein- und Ausbau des Einschubgehäuses 10 eine sichere Kontaktierung. Es kann gegebenenfalls auch als Rastverbindung dienen.

Das freie Ende 6 kann im Ruhezustand des federnden Kontaktelementes 2 am Blech 1 anliegen; vorteilhaft ist ein geringer Abstand zwischen dem freien Ende 6 und den Stützflächen 22 ausgebildet.

Wirkt auf das federnde Kontaktelement über das Einschubgehäuse 10 in Pfeilrichtung 19 eine Kraft, liegt das federnde Ende 6 auf dem Blech 1 auf und wird - aufgrund der Krafteinwirkung in Pfeilrichtung 19 - beim Einbau in Richtung des Doppelpfeils 24 leicht hin- und herreiben. Dadurch wird auch im Bereich des freien Endes 6 eine elektrische Kontaktierung des federnden Kontaktelementes mit dem es tragenden 3lech 1 sichergestellt, so daß der bogenförmige Laschenabschnitt einerseits über den einteiligen Anschluß mit dem Fußabschnitt elektrisch leitend mit dem Blech 1 verbunden ist und andererseits über das sich auf dem Blech 1 abstützende freie Ende 6. Dabei wird aufgrund der Bewegung in Richtung des Doppelpfeils 24 bei jedem Einbau ein Freireiben der Kontaktstelle erreicht, wodurch über eine lange Zeit eine sichere Kontaktierung gewährleistet ist. Bei Kontaktelementen/ die aus beschichtetem oder lackiertem Blech gefertigt sind, wird diese Beschichtung im Bereich der elektrisch leitenden Kontaktflächen 5, 21 entfernt oder durch Biegen oder Umfalzen eine Kontaktfläche geschaffen.

Es kann vorteilhaft sein, die Breite des Stützbereiches 21 vor der Kaltverformung kleiner als den Abstand a der Stützflächen 22 auszuführen, wobei dann erst durch die Kaltverformung die Breite B1 des Stützbereiches 21 erzielt wird, welcher größer als der Abstand a der Stützflächen 22 zueinander ist. Entscheidend ist eine ausreichende überdeckung u zwischen dem Stützbereich 21 und den Stützflächen 22, um eine sichere Abstützung und weitgehend verformungsfreie Ableitung der Stützkräfte in das Blech 1 des Gehäuseteils sicherzustellen.

Es kann ausreichend sein, als Stützfläche 22 lediglich einen in den Längsschlitz 11 einragenden Blechabschnitt 30 vorzusehen, wie dies in Fig. 1A gezeigt ist. Die in Fig. 1B geradlinig ausgebildete Blechlasche 2 ist in Fig. 1A in Draufsicht winklig um den einragenden Blechabschnitt 30 geführt und besteht somit im wesentlichen aus zwei zueinander etwa parallelen Laschenabschnitten 2a, 2b sowie quer dazu liegenden Verbindungsabschnitten 2c. Die zur Erlangung der Federeigenschaften notwendige Kaltverformung erfolgt im wesentlichen in den Laschenabschnitten 2a und 2b. Die zur Erzielung der Federeigenschaften notwendige Formgebung bewirkt ein Verkürzen der Lasche 2 in Laschenlängsrichtung, so daß das Ende 6 auf dem Blechabschnitt 30 zu liegen kommt und sich dort abstützt.

## Patentansprüche

1. Federndes Kontaktelement zur Anordnung zwischen elektrisch leitenden Gehäuseteilen (10, 20), insbesondere zwischen einem Einschubgehäuse (10) und einem Einbauschacht (20), wobei ein Gehäuseteil (20) ein formbares Blech (1) aufweist, welches eine einteilig aus einem Schlitz (11) des Bleches (1) ausgeformte Blechlasche (2) umfaßt, die zur Bildung des federnden Kontaktelementes durch Kaltverformung gegenüber dem Blech (1) in der Dicke (d) reduziert ist und sich bogenförmig aus der Ebene (16) des Bleches (1) erhebt, wobei das Kontaktelement mit einem Fußabschnitt (3) am Blech (1) gehalten und in einem mit Abstand zum Fußabschnitt (3) liegenden Stützbereich (21) am Blech (1) abgestützt ist,
**dadurch gekennzeichnet, daß** dem Stützbereich (21) des Kontaktelementes (2) eine Stützfläche (22) des Bleches (1) zugeordnet ist, die sich quer zur Laschenlängsachse (13) vom Schlitzlängsrand (23) aus erstreckt und den Stützbereich (21) untergreift.

2. Kontaktelement nach Anspruch 1,
**dadurch gekennzeichnet, daß** der Stützbereich (21) am freien Ende (6) der Blechlasche (2) ausgebildet ist.

3. Kontaktelement nach Anspruch 1 oder 2,
**dadurch gekennzeichnet, daß** an den Schlitzlängsrändern (23) sich quer zur Laschenlängsachse (13) mit Abstand (a) gegenüberliegende Stützflächen (22) vorgesehen sind.

4. Kontaktelement nach Anspruch 3,
**dadurch gekennzeichnet, daß** die größte Breite (B) des Stützbereiches (6) vor der Kaltverformung geringfügig größer als der Abstand (a) der Stützflächen (22) ist.

5. Kontaktelement nach Anspruch 3,
**dadurch gekennzeichnet, daß** die vor der Kaltverformung eine kleiner als der Abstand (a) der Stützflächen (22) aufweisende Breite des Stützbereiches (21) durch die Kaltverformung größer als der Abstand (a) verformt ist.

6. Kontaktelement nach einem der Ansprüche 1 bis 5,
**dadurch gekennzeichnet, daß** das freie Ende (6) der Blechlasche (2) in Draufsicht tellerartig verformt ist.

7. Kontaktelement nach Anspruch 6,
**dadurch gekennzeichnet, daß** das tellerförmige Ende (6) etwa über einen quer zur Schlitzlängsachse (13) liegenden Durchmesser (18) abgebogen ist.

8. Kontakteiement nach einem der Ansprüche 1 bis 7,
**dadurch gekennzeichnet, daß** eine Stützfläche (22) durch einen in den Schlitz (11) einragenden Randabschnitt (15) des Schlitzlängsrandes (23) ausgebildet ist.

9. Kontaktelement nach einem der Ansprüche 1 bis 8,
**dadurch gekennzeichnet, daß** die Kontaktfläche (5) des Kontaktelementes zwischen dem Fußabschnitt (3) und dem Stützbereich (21) liegt, vorzugsweise etwa im höchsten Punkt des bogenförmigen Laschenabschnittes (4).

10. Kontaktelement nach einem der Ansprüche 1 bis 9,
**dadurch gekennzeichnet, daß** der Fußabschnitt (3) gewellt, insbesondere S-förmig gewellt, ausgebildet ist.

11. Kontaktelement nach einem der Ansprüche 1 bis 10,
**dadurch gekennzeichnet, daß** die Stützfläche (22) in Richtung der Schlitzlängsachse (13) länger als der Stützbereich (21) ausgebildet ist.

12. Kontaktelement nach einem der Ansprüche 1 bis 11,
**dadurch gekennzeichnet, daß** der Stützbereich (21) im unbelasteten Zustand des Kontaktelementes mit geringem Abstand zur Stützfläche (22) liegt, vorzugsweise an der Stützfläche (22) anliegt.

## Claims

1. A spring contact element to be positioned between electrically conductive housing sections (10, 20), in particular between a plug-in housing (10) and a receiving shaft (20), one housing part (20) having a ductile plate (1) which comprises a plate clip (2) formed in one part from a slit (11) in the plate (1), the thickness (d) of which is reduced in relation to the plate (1) by cold forming in order to form the spring contact element and curves upwards from the plane (16) of the plate (1), the contact element being held onto the plate (1) by a foot section (3) and supported on the plate (2) in a supporting area (21) a certain distance from the foot section (3),
**characterised in that**
assigned to the supporting area (21) of the contact element (2) is a supporting surface (22) of the plate which extends from the longitudinal edge (23) of the slit (11) across the longitudinal axis (13) and engages under the supporting area (21).

2. A contact element in accordance with claim 1
**characterised in that**
the supporting area (21) is positioned at the free end (6) of the plate clip (2).

3. A contact element in accordance with claim 1 or 2,
**characterised in that**
supporting surfaces (22) a certain distance (a) apart and running across the longitudinal axis (13) are provided at the longitudinal edges (23) of the slit (11).

4. A contact element in accordance with claim 3,
**characterised in that**
the greatest width (B) of the supporting area (6) prior to cold forming is slightly greater than the distance (a) between the supporting surfaces (22).

5. A contact element in accordance with claim 3,
**characterised in that**
the width of the supporting area (21) which is smaller than the distance between the supporting surfaces (22) prior to cold forming is made greater than the distance (a) by the cold forming.

6. A contact element in accordance with one of claims 1 to 5,
**characterised in that**
in top view the free end (6) of the plate clip (2) is disc-shaped.

7. A contact element in accordance with claim 6,
**characterised in that**
the disc-shaped end (6) is curved along a diameter (18) which lies across the longitudinal axis (13) of the slit (11).

8. A contact element in accordance with one of claims 1 to 7,
**characterised in that**
a supporting surface (22) is formed by a section (15) of the longitudinal edge (23) of the slit (11) which projects into the slit (11).

9. A contact element in accordance with one of claims 1 to 8,
**characterised in that**
the contact surface (5) of the contact element lies between the foot section (3) and the supporting area (21), preferably roughly at the highest point of the curved section (4) of the clip (2).

10. A contact element in accordance with one of claims 1 to 9,
**characterised in that**
the foot section (3) is undulated, particularly undulated in an S-shape.

11. A contact element in accordance with one of claims 1 to 10,
**characterised in that**
the supporting surface (22) is longer along the longitudinal axis (13) of the slit (11) than the supporting area (21).

12. A contact element in accordance with one of claims 1 to 11,
**characterised in that**
when the contact element in not under load, the supporting area (21) lies close to the supporting surface (22), preferably touching the supporting surface (22).

## Revendications

1. Élément de contact flexible à agencer entre des parties de boîtier (10, 20) électro-conductrices, en particulier entre un rack (10) et une baie (20), sachant qu'une partie de boîtier (20) comporte une tôle (1) déformable, laquelle comprend une patte (2), qui est réalisée d'une seule pièce à partir d'une fente (11) de la tôle (1) et dont l'épaisseur (d) a été réduite par rapport à la tôle (1) par formage à froid en vue de former l'élément de contact flexible et qui s'élève en forme de courbe au-dessus du plan (16) de la tôle (1), sachant que l'élément de contact est maintenu contre la tôle (1) par une partie formant le pied (3) et est en appui contre la tôle (1) dans une zone d'appui (21) située à une distance donnée du pied (3), **caractérisé en ce que** la zone d'appui (21) de l'élément de contact (2) est associée à une surface de support (22) de la tôle (1), qui s'étend transversalement à l'axe longitudinal (13) de la patte à partir du bord longitudinal (23) de la fente et s'engage en dessous de la zone d'appui (21).

2. Élément de contact selon la revendication 1, **caractérisé en ce que** la zone d'appui (21) est réalisée sur l'extrémité libre (6) de la patte (2) en tôle.

3. Élément de contact selon la revendication 1 ou 2, **caractérisé en ce que** sur les bords longitudinaux (23) de la fente sont prévues des surfaces de support (22) situées face à face à une distance (a) transversalement à l'axe longitudinal (13) de la patte.

4. Élément de contact selon la revendication 3, **caractérisé en ce que** la plus grande largeur (B) de la zone d'appui (21) est, avant le formage à froid, légèrement plus grande que la distance (a) entre les surfaces de support (22).

5. Élément de contact selon la revendication 3, **caractérisé en ce que** la largeur de la zone d'appui (21), plus petite que la distance (a) entre les surfaces de support (22) avant le formage à froid, est déformée par le formage à froid pour être plus grande que la distance (a).

6. Élément de contact selon l'une quelconque des revendications 1 à 5, **caractérisé en ce que** l'extrémité libre (6) de la patte (2) en tôle est déformée en forme de disque sur une vue de dessus.

7. Élément de contact selon la revendication 6, **caractérisé en ce que** l'extrémité (6) en forme de disque est cintrée sensiblement sur un diamètre (18) orienté transversalement à l'axe longitudinal (13) de la fente.

8. Élément de contact selon l'une quelconque des revendications 1 à 7, **caractérisé en ce qu'**une surface de support (22) est formée par une partie (15) du bord longitudinal (23) de la fente, laquelle s'engage à l'intérieur de la fente (11).

9. Élément de contact selon l'une quelconque des revendications 1 à 8, **caractérisé en ce que** la surface de contact (5) de l'élément de contact est située entre le pied (3) et la zone d'appui (21), de préférence presque au point le plus haut de la partie cintrée (4) de la patte.

10. Élément de contact selon l'une quelconque des revendications 1 à 9, **caractérisé en ce que** le pied (3) est ondulé, en particulier ondulé en forme de S.

11. Élément de contact selon l'une quelconque des revendications 1 à 10, **caractérisé en ce que** la surface de support (22) est plus longue que la zone d'appui (21) en direction de l'axe longitudinal (13) de la fente.

12. Élément de contact selon l'une quelconque des revendications 1 à 11, **caractérisé en ce que** la zone d'appui (21), à l'état non sollicité de l'élément de contact, est disposée à une faible distance de la surface de support (22), de préférence est en appui contre la surface de support (22).
